# EUROPEAN PATENT SPECIFICATION

(11) **EP 2 835 837 B1**
(45) Date of publication and mention of the grant of the patent: **07.08.2019**
(21) Application number: 13772536.2
(22) Date of filing: 15.03.2013
(51) Int. Cl.: H01L 33/62, H01L 25/075, H01L 33/60

(54) **Light emitting device with light emitting diodes**
Lichtemittierende Vorrichtung mit Leuchtdioden
Dispositif lumineux à diodes électroluminescentes

(30) Priority: 06.04.2012 JP 2012087358
(43) Date of publication of application: 11.02.2015
(73) Proprietor: Citizen Electronics Co., Ltd., Fujiyoshida-shi, Yamanashi 403-0001 (JP); Citizen Watch Co., Ltd., Tokyo 188-8511 (JP)
(72) Inventor: FUNAKUBO, Takuya, Fujiyoshida-shi Yamanashi 403-0001 (JP)
(74) Representative: Patentanwälte Ruff, Wilhelm, Beier, Dauster & Partner mbB
(86) International application number: PCT/JP2013/057551
(87) International publication number: WO 2013/150882

(56) References cited:
- EP-A2- 2 290 279
- EP-A2- 2 365 525
- WO-A1-2011/129202
- WO-A1-2011/129202
- WO-A1-2011/129203
- JP-A- 2006 005 290
- JP-A- 2007 129 053
- JP-A- 2008 288 230
- JP-A- 2011 009 298
- US-A1- 2009 166 657
- US-A1- 2010 193 822
- US-A1- 2010 320 483
- US-A1- 2011 254 022
- US-A1- 2012 080 713

## Description

The present invention relates to an LED light emitting apparatus constructed by mounting a plurality of LED devices in a device mounting region enclosed by a sealing frame, and more particularly to an LED light emitting apparatus according to the preamble of claim 1.

In recent years, LED devices as semiconductor devices have come into wide use in applications such as color display backlighting, illumination, and the like, because of their long life, excellent driving characteristics, compact size, and good luminous efficacy as well as their capability to produce crisp, bright colors.

Among others, there have been proposed a variety of LED light emitting apparatus for producing light of high brightness by mounting a plurality of LED devices in a device mounting region of a predefined shape (for example, refer to patent documents 1 and 2).

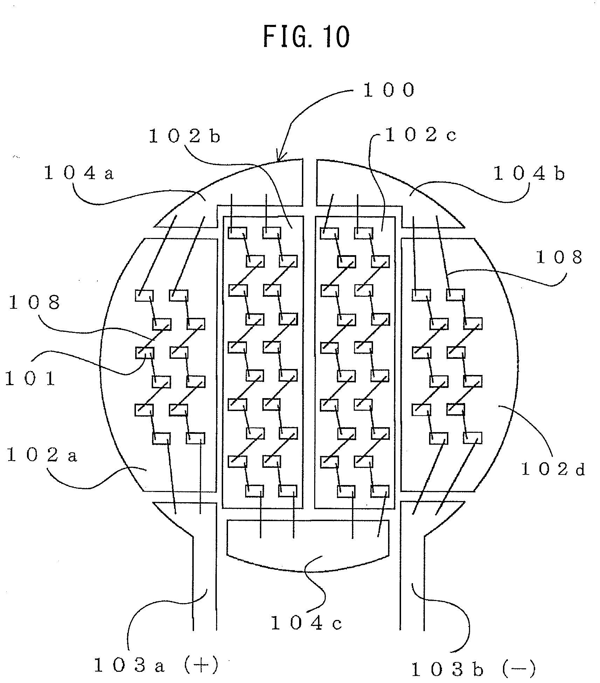

Figure 10 is a plan view showing a light-emitting portion of an LED light emitting apparatus disclosed in JP 2010-287656 A (patent document 1). In Figure 10, the diagram is simplified in part and, for ease of comparison, some of the component elements are referred to by the same names as those used in the present patent application.

As shown in Figure 10, the LED light emitting apparatus 100 includes a circular device mounting region which is divided into four smaller regions, i.e., the first mounting region 102a, the second mounting region 102b, the third mounting region 102c, and the fourth mounting region 102d. The circular device mounting region is surrounded by two power electrodes 103a and 103b and three relay electrodes 104a, 104b, and 104c.

The two mounting regions 102b and 102c near the center each accommodate twenty LED devices 101 in two strings of ten LED devices 101 arranged in a staggered fashion. The ten LED devices 101 in each string are connected in series by wires 108. Further, the two strings of series-connected LED devices are connected to the relay electrodes 104a, 104b and 104c by wires 108. More specifically, in the mounting region 102b, the two LED strings each consisting of ten LED devices connected in series are connected in parallel between the relay electrodes 104a and 104c, while in the mounting region 102c, the two LED strings each consisting of ten LED devices connected in series are connected in parallel between the relay electrodes 104b and 104c.

Similarly, the two mounting regions 102a and 102d on both sides each accommodate twelve LED devices 101 in two strings of six LED devices 101 arranged in a staggered fashion. The six LED devices 101 in each string are connected in series by wires 108. Further, the two strings of series-connected LED devices are connected between the relay electrode 104a and the power electrode 103a or between the relay electrode 104b and the power electrode 103b by wires 108. More specifically, in the mounting region 102a, the two LED strings each consisting of six LED devices connected in series are connected in parallel between the relay electrode 104a and the power electrode 103a, while in the mounting region 102d, the two LED strings each consisting of six LED devices connected in series are connected in parallel between the relay electrode 104b and the power electrode 103b.

In the above configuration, when the power electrode 103a is designated as the positive electrode (+) and the power electrode 103b as the negative electrode (-), two LED strings each consisting of six LED devices connected in series are mounted in each of the mounting regions 102a and 102d and connected between the power electrodes 103a and 103b, while on the other hand, two LED strings each consisting of ten LED devices connected in series are mounted in each of the mounting regions 102b and 102c and connected between the power electrodes 103a and 103b. The LED strings mounted in the respective mounting regions are all connected in series between the power electrodes 103a and 103b via the relay electrodes 104a, 104c, and 104b. Therefore, the total number of the series-connected LED devices 101 in the four mounting regions is given as 6 + 10 + 10 + 6 = 32; if the drive voltage of each LED device is 3 V, then 3 × 32 = 96 V. This means that when the voltage of 96 V is applied between the power electrodes 103a and 103b, all the LED devices 101 emit light.

Figure 11 is a perspective view showing an LED light emitting apparatus disclosed in JP 2009-164157 A (patent document 2). In Figure 11, the diagram is simplified in part and, for ease of comparison, some of the component elements are referred to by the same names as those used in the present patent application.

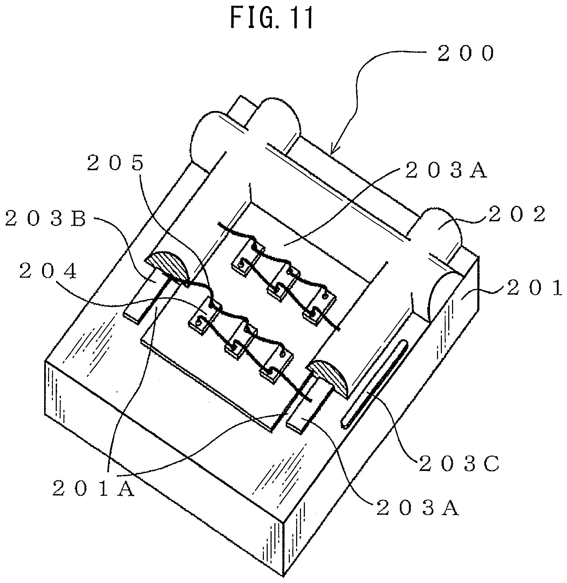

As shown in Figure 11, the LED light emitting apparatus 200 includes a rectangular circuit substrate 201 having conductive interconnection patterns 203A, 203B, and 203C on its upper surface, and a plurality of LED devices 204 mounted on the conductive interconnection pattern 203A. A sealing frame 202 formed from a reflective white resin for reflecting light emitted from the LED devices 204 is provided so as to surround the LED devices 204. The LED devices 204 are electrically connected to the conductive interconnection patterns 203A and 203B by wires 205. The conductive interconnection pattern 203C is provided as a guide mark to indicate the polarity.

The conductive interconnection pattern 203A is formed so that the region in which the LED devices 204 are mounted and the region to which the wires 205 are connected are connected together in portions buried under the sealing frame 202 (though not shown here). The sealing frame 202 is provided so that portions of the region of the conductive interconnection pattern 203A on which the LED devices 204 are mounted, regions 201A exposed on the circuit substrate 201 between the conductive interconnection patterns 203A and 203B to which the wires 205 are connected, and portions of the wires 205 connecting the LED devices 204 to the conductive interconnection patterns 203A and 203B are buried under the sealing frame 202.

Since portions of the wires 205 and the regions 201A exposed on the circuit substrate 201 are buried under the sealing frame 202, the amount of light emitted from the LED devices 204 and absorbed by the wires 205 and the regions 201A exposed on the circuit substrate 201 is reduced, thereby increasing light extraction efficiency.

In an LED light emitting apparatus constructed by mounting a plurality of LED devices on a substrate having a device mounting region and a pair of opposing electrodes disposed outside the device mounting region and by providing a sealing frame around the device mounting region while connecting the LED devices to the opposing electrodes by wires, there is a need to increase the light extraction efficiency from the device mounting region while at the same time enhancing the reliability of connections to the LED devices.

In the LED light emitting apparatus 100 disclosed in patent document 1, the plurality of LED devices are arranged for mounting in a near circular geometry in the device mounting region having a circular shape, but since the device mounting region is split into a plurality of portions, portions of poor reflectivity are left between the split portions of the device mounting region. As a result, the reflectivity of the device mounting region as a whole decreases, resulting in the problem that the light extraction efficiency does not increase. Furthermore, because of the absence of a reflective frame for gathering light scattering from the device mounting region and for directing it in the forward direction, there is also the problem that it is not possible to increase the light extraction efficiency as a whole.

In the LED light emitting apparatus 200 disclosed in patent document 2, since the region in which the LED devices 204 are mounted and the region to which the wires 205 are connected are formed integrally as the conductive interconnection pattern 203A, the surfaces of these regions are treated under the same conditions. However, the conditions required for the surface treatment of the LED device mounting region (the treatment for increasing the light extraction efficiency) are different from the conditions required for the surface treatment of the wire connecting region (the treatment for reliably connecting the wires). As a result, in the LED light emitting apparatus 200, it is difficult to increase the light extraction efficiency while at the same time enhancing the reliability of connections to the LED devices.

Generally, in the case of a metallic film, a white or whitish film such as a silver or aluminum film is preferred for use as a reflector. On the other hand, a representative metal that has high connection reliability is gold. For example, when forming the conductive interconnection pattern 203A by plating, the region to which the wires 205 are to be connected is plated with gold so that high connection reliability can be obtained. However, in this case, the gold plating is also applied at the same time to the region of the conductive interconnection pattern 203A where the LED devices 204 are to be mounted. Since the layer of gold plating has poor reflectivity and absorbs light emitted from the LED devices 204, high radiative efficiency cannot be obtained.

When silver plating is applied to the conductive interconnection pattern 203A so that the region in which the LED devices 204 are mounted will have high reflectivity, the reflectivity of the region in which the LED devices 204 are mounted improves. However, in this case, the silver plating is also applied at the same time to the region of the conductive interconnection pattern 203A where the LED devices 204 are to be mounted. Since the layer of silver plating has poor bonding to the wires 205, the reliability of connections to the LED devices degrades.

As can be seen from the above, there is a need to form a gold layer having good bonding in the region of the conductive interconnection pattern 203A to which the wire leads are to be connected, and to form a silver layer having good reflectivity in the region in which the LED devices are to be mounted. However, in the LED light emitting apparatus 200, the region in which the LED devices 204 are mounted and the region to which the wires 205 are connected are formed integrally as the conductive interconnection pattern 203A. As a result, in the LED light emitting apparatus 200, it is difficult to increase the light extraction efficiency while at the same time enhancing the reliability of connections to the LED devices. (Figure 9A in patent document 2 shows a structure in which a silver-plated layer is formed on an integrally formed wiring electrode pattern.) US 2012/0080713 A1 discloses an LED light emitting apparatus according to the preamble of claim 1.

JP2011-205055-A discloses a light-emitting module with improved reflection.

It is the technical problem underlying the invention to provide an LED light emitting apparatus that makes it possible to increase light extraction efficiency while at the same time enhancing the reliability of connections to LED devices.

The invention solves this problem by providing an LED light emitting apparatus having the features of claim 1. Advantageous embodiments of the invention are mentioned in the dependent claims, the wording of which is herewith incorporated into the description by reference. The LED light emitting apparatus according to the invention can be constructed so as to be able to achieve a high radiative efficiency by forming a reflective layer in the device mounting region and mounting the plurality of LED devices on the reflective layer.

According to the invention, the opposing electrodes are plated with gold to improve the wire bondability of the LED devices thereby enhancing the reliability of connections, while on the other hand, the reflective layer is formed in the device mounting region and the sealing frame is formed around the device mounting region in such a manner that the inner circumference of the sealing frame overlaps the outer circumference of the reflective layer and thus covers the side face of the opening formed in the circuit substrate, minimizing the loss of light therein; with this structure, the light extraction efficiency from the device mounting region can be greatly increased.

Preferably, in the LED light emitting apparatus, the reflective layer is a metal plate that covers a bottom face exposed through an opening formed in a circuit substrate on which the pair of opposing electrodes is formed, and the sealing frame is formed so as to cover a portion extending from an upper face of the circuit substrate to a side face of the opening and further to a surface of the metal plate.

Preferably, in the LED light emitting apparatus, the metal plate is an aluminum plate.

Preferably, in the LED light emitting apparatus, the reflective layer is an insulating film treated for high reflectivity formed on the surface of the metal plate.

According to the above configuration, since the mounting substrate that provides the device mounting region is constructed from a metal plate having excellent heat dissipation characteristics, and since the opposing electrodes are formed as wiring electrodes on the circuit substrate, the gold plating of the opposing electrodes and the formation of a high-reflectivity insulating layer in the device mounting region can be performed independently of each other; as a result, not only the light extraction efficiency from the device mounting region and the reliability of connections to the LED devices but also the heat dissipation performance can be enhanced.

Preferably, in the LED light emitting apparatus, the reflective layer is a white reflective insulating layer formed on the circuit substrate on which the pair of opposing electrodes is formed, and the sealing frame is formed so as to cover a portion extending from the upper face of the circuit substrate and overlapping the outer circumference of the white reflective layer.

Preferably, in the LED light emitting apparatus, the white reflective layer is a ceramic ink layer or a white reflective resin layer.

Preferably, in the LED light emitting apparatus, the white reflective layer is formed by depositing a silver-plated layer and a transparent insulating layer one on top of the other on the circuit substrate on which the pair of opposing electrodes is formed.

Preferably, in the LED light emitting apparatus, the reflective layer formed in the device mounting region has a circular shape.

Preferably, in the LED light emitting apparatus, the sealing frame is formed from a reflective white resin.

Preferably, the LED light emitting apparatus further comprises a phosphor layer, formed inside the sealing frame, for modulating light emitted from the plurality of LED devices and thereby converting the light into white light.

Preferably, in the LED light emitting apparatus, the plurality of LED devices are blue LED devices, and the phosphor layer is a YAG phosphor layer.

Preferably, in the LED light emitting apparatus, the plurality of LED devices are ultraviolet LED devices, and the phosphor layer is an RGB phosphor layer.

According to the LED light emitting apparatus described above, the light extraction efficiency can be increased while at the same time enhancing the reliability of connections to the LED devices.

Advantageous embodiments of the invention are described in the following and illustrated in the drawings, in which:
Figure 1 is a plan view of an LED light emitting apparatus.
Figure 2 is a cross-sectional view taken along ling A-A' in Figure 1.
Figure 3 is a cross-sectional view taken along ling B-B' in Figure 1.
Figure 4 is a plan view of an LED light emitting apparatus as a modified example of the LED light emitting apparatus of Figure 1.
Figure 5 is a cross-sectional view taken along ling C-C' in Figure 4.
Figure 6 is a plan view of an alternative LED light emitting apparatus.
Figure 7 is a cross-sectional view taken along ling D-D' in Figure 6.
Figure 8 is a plan view of a further alternative LED light emitting apparatus.
Figure 9 is a cross-sectional view taken along ling E-E' in Figure 8.
Figure 10 is a plan view showing a light-emitting portion of an LED light emitting apparatus disclosed in patent document 1.
Figure 11 is a perspective view showing an LED light emitting apparatus disclosed in patent document 2.

Exemplary embodiments of the LED light emitting apparatus according to the invention will be described below with reference to the drawings. It will, however, be noted that the technical scope of the present invention is not limited by any particular embodiment described herein but extends to the inventions described in the appended claims and their equivalents. Further, in the description of the drawings, the same or corresponding component elements are designated by the same reference numerals, and the description of such component elements, once given, will not be repeated thereafter.

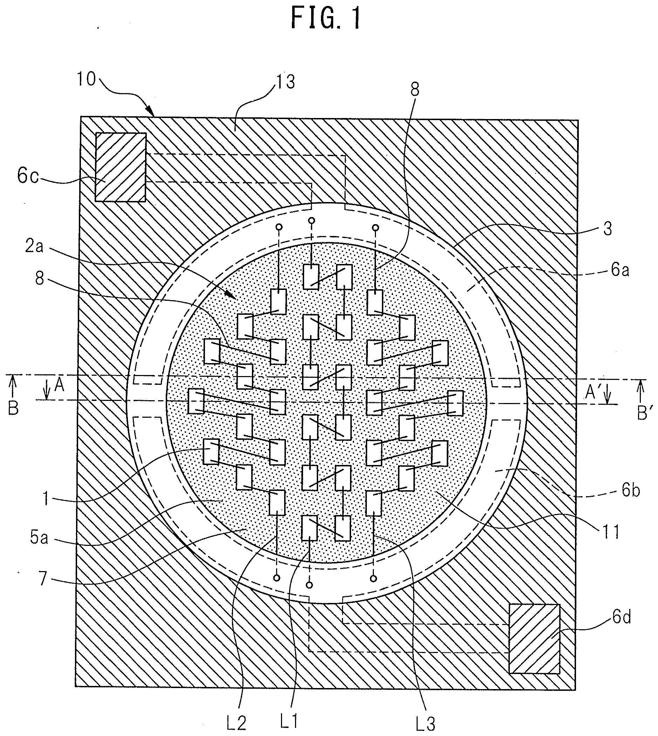

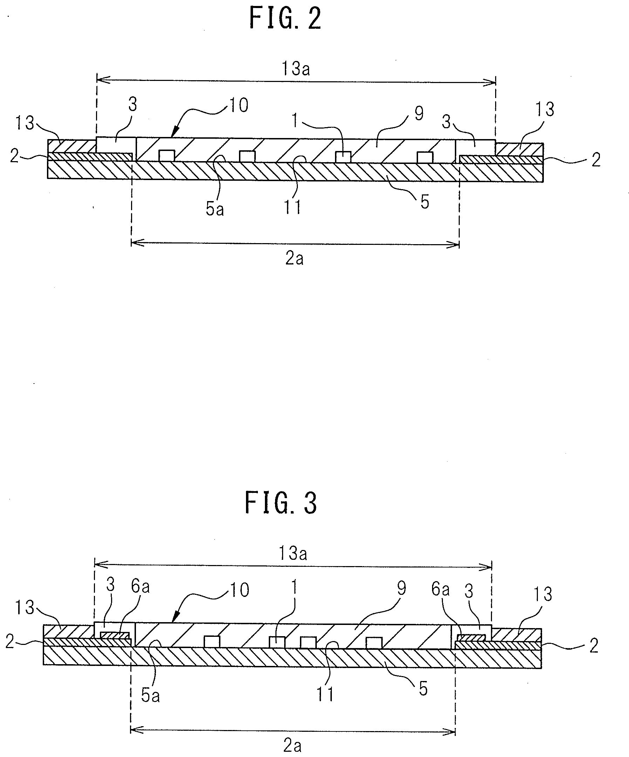

Figure 1 is a plan view of an LED light emitting apparatus 10, Figure 2 is a cross-sectional view taken along ling A-A' in Figure 1, and Figure 3 is a cross-sectional view taken along ling B-B' in Figure 1.

As shown in Figures 1 and 2, in the LED light emitting apparatus 10, a metal plate 5 is used as a mounting substrate, a circuit substrate 2 having a circular opening 2a in the center is placed on the metal plate 5, and a circular portion 5a of the metal plate 5, which is exposed through the opening 2a of the circuit substrate 2, is used as a circular device mounting region 7. An aluminum plate having good reflectivity is used as the metal substrate 5, and a transparent insulating layer or an insulating layer treated for high reflectivity is formed on the surface of the metal plate 5 to protect the metal plate 5, to improve the reflectivity of the metal plate 5, and to provide electrical insulation from the metal plate 5.

The circular portion 5a of the metal plate 5 which forms the device mounting region 7 is an aluminum plate or a reflective layer 11 treated for high reflectivity. LED devices 1 are fixedly mounted on the reflective layer 11 in the device mounting region 7. LED connecting electrodes 6a and 6b (indicated by dashed lines in Figure 1), each with a gold-plated layer formed thereon, are provided as a pair of opposing electrodes on the circuit substrate 2 in such a manner as to surround the opening 2a. A sealing frame 3 formed from a reflective resin is provided around the periphery of the device mounting region 7 in such a manner as to cover the LED connecting electrodes 6a and 6b.

A resist 13 is applied to cover the circuit substrate 2 outside the sealing frame 3. That is, the resist 13 has an opening 13a whose diameter is larger than the diameter of the opening 2a in the circuit substrate 2, and is formed so as to cover the entire surface of the circuit substrate 2 up to the edges thereof except where power connecting electrodes 6c and 6d are formed.

The sealing frame 3 is formed so that its inner circumference covers the portion extending from the upper face of the circuit substrate 2 to the side face of the opening 2a and overlapping the outer circumference of the reflective layer 11 formed on the metal plate, and so that its outer circumference is located inside the opening 13a and covers the LED connecting electrodes 6a and 6b. The region surrounded by the sealing frame 3 is sealed with a sealing resin 9 such as a transparent resin or a phosphor resin. The power connecting electrodes 6c and 6d connected to the LED connecting electrodes 6a and 6b, respectively, are formed at positions outside the sealing frame 3 so as to oppose each other across the device mounting region 7. The LED devices 1 are top-electrode type LED devices. Connections between the electrodes of the LED devices 1 and connections from the LED devices 1 to the LED connecting electrodes 6a and 6b are made by wires 8.

The plurality of LED devices 1 mounted in the device mounting region 7 are arranged to form a plurality of LED strings between the pair of LED connecting electrodes 6a and 6b provided at the top and bottom. LED strings each consisting of six LED devices 1 are formed in the center of the device mounting region 7, and an LED string of five LED devices, an LED string of four LED devices, and an LED string of three LED devices are formed one adjacent to another on each side of the center. As a whole, the LED devices 1 are arranged in a near circular geometry in the device mounting region 7.

The two LED strings each consisting of six LED devices 1 arranged in the center are connected in series by wires 8 to form a first LED device group L1 of twelve LED devices 1 between the pair of LED connecting electrodes 6a and 6b. The LED string of five LED devices, the LED string of four LED devices, and the LED string of three LED devices, arranged on each side of the center, are also connected in series by wires 8 to form a second LED device group L2 on one side and a third LED device group L3 on the other side, each formed from twelve LED devices 1, between the pair of LED connecting electrodes 6a and 6b.

As described above, the first LED device group L1, the second LED device group L2, and the third LED device group L3, each formed from twelve LED devices 1, are connected in parallel between the pair of LED connecting electrodes 6a and 6b. In each of the second and third LED device groups L2 and L3, the three LED strings, i.e., the LED string of five LED devices, the LED string of four LED devices, and the LED string of three LED devices, are connected in series. As can be seen from Figure 1, when connecting many LED strings in series, it is easier to interconnect the electrodes of the LED devices 1 by wires 8 if the electrodes of the LED devices 1 are oriented in parallel to the direction across which the LED connecting electrodes 6a and 6b oppose each other.

In the LED light emitting apparatus 10, the metal plate 5 prepared by forming a high-reflectivity layer on a metal plate such as an aluminum plate is used as the mounting substrate, and the LED devices 1 are fixedly mounted directly on the reflective layer 11 formed on the metal plate 5; this serves to increase heat dissipation from the LED devices 1 and to produce light of high output power. Further, in the LED light emitting apparatus 10, the reflective layer 11 is formed in the device mounting region 7, and the reflective sealing frame 3 is provided around the device mounting region 7 in such a manner that the inner circumference of the sealing frame 3 overlaps the outer circumference of the reflective layer 11. Furthermore, in the LED light emitting apparatus 10, since the device mounting region 7 is enclosed by only the reflective members, i.e., the reflective layer 11 and the reflective resin frame 3, the light emitted from the LED devices 1 is not absorbed by the opening 2a in the circuit substrate 2 nor is it absorbed by the gold-plated layers formed on the LED connecting electrodes 6a and 6b. As a result, in the LED light emitting apparatus 10, all the light emitted from the LED devices 1 is reflected by the reflective layer 11 and the reflective resin frame 3 (the reflective efficiency is extremely high), thus achieving a high radiative efficiency.

In the LED light emitting apparatus 10, since the gold-plated layer is formed on each of the LED connecting electrodes 6a and 6b, the wire bondability of the LED devices 1 improves, which serves to increase the connection reliability. Accordingly, in the LED light emitting apparatus 10, the radiative efficiency can be increased while at the same time increasing the connection reliability.

For the high-reflective layer formed as the reflective layer 11 in the device mounting region 7, use is preferably made of an enhanced reflective film such as a dielectric multilayer film; however, when the metal plate 5 is formed from a highly reflective material such as aluminum or silver, such an enhanced reflective film need not necessarily be used, but use may be made of a transparent insulating film to provide insulation.

In the LED light emitting apparatus 10, the insulating layer is formed on the surface of the metal plate 5, and the LED devices 1 are fixedly mounted thereon. Generally, the top-electrode type LED devices can be fixedly mounted directly on the surface of the metal plate, but when the large number of LED devices 1 are mounted in the circular device mounting region 7 as shown in Figure 1, the voltage applied between the terminals of the LED devices 1 may increase. Therefore, in the LED light emitting apparatus 10, the insulating layer is provided to ensure insulation for the LED devices 1.

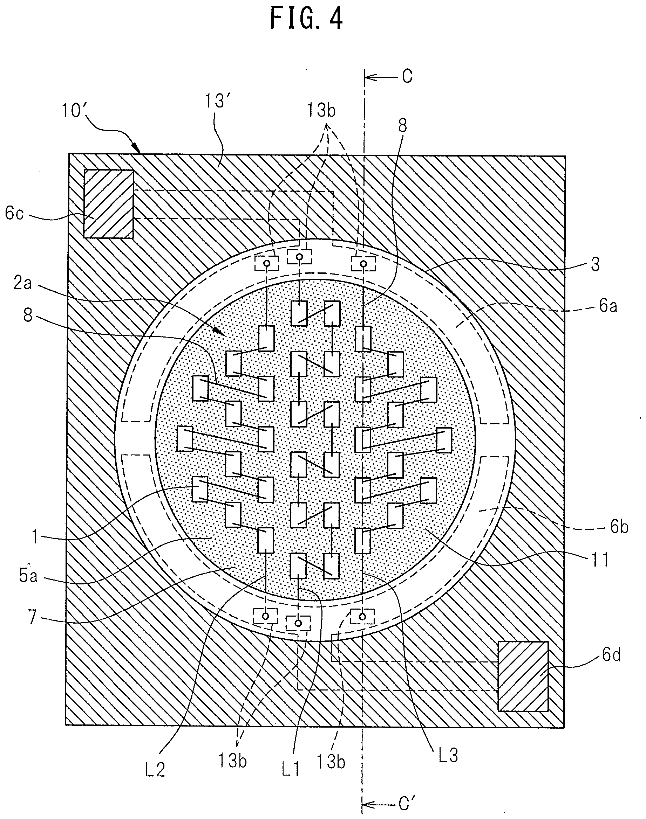

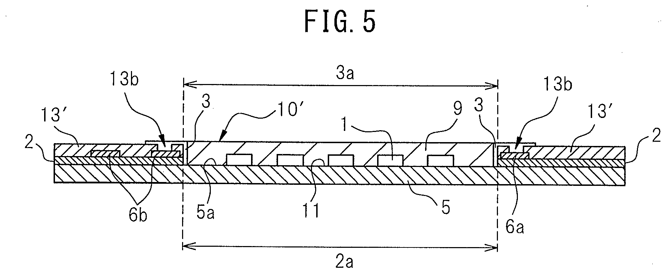

Figure 4 is a plan view of an LED light emitting apparatus 10' as a modified example of the LED light emitting apparatus 10, and Figure 5 is a cross-sectional view taken along ling C-C' in Figure 4.

The difference between the LED light emitting apparatus 10' of Figure 4 and the LED light emitting apparatus 10 of Figure 1 lies in the pattern of the resist 13' formed in the LED light emitting apparatus 10' of Figure 4; otherwise, the configuration is the same as that of the LED light emitting apparatus 10 shown in Figure 1.

In the LED light emitting apparatus 10' shown in Figure 4, the resist 13' has an opening 13a, whose diameter is substantially the same as that of the opening 2a in the circuit substrate 2, and six openings 13b formed in positions where the LED devices 1 are connected to the LED connecting electrodes 6a and 6b by wires 8. That is, the resist 13' is formed so as to cover the LED connecting electrodes 6a and 6b everywhere except where the openings 13b are formed. Further, the resist 13' is formed so as to cover the entire surface of the circuit substrate 2 up to the edges thereof except where the power connecting electrodes 6c and 6d are formed. With this arrangement, the sealing frame 3 is formed so that its inner circumference is located inside the opening 13a of the resist 13' and so that its outer circumference covers the LED connecting electrodes 6a and 6b and overlaps a portion of the resist 13'.

In the LED light emitting apparatus 10' shown in Figure 4, since the area where the sealing frame 3 contacts the resist 13' is larger than that in the LED light emitting apparatus 10 of Figure 1, the two members can be bonded together more firmly, and the reliability of the LED light emitting apparatus increases.

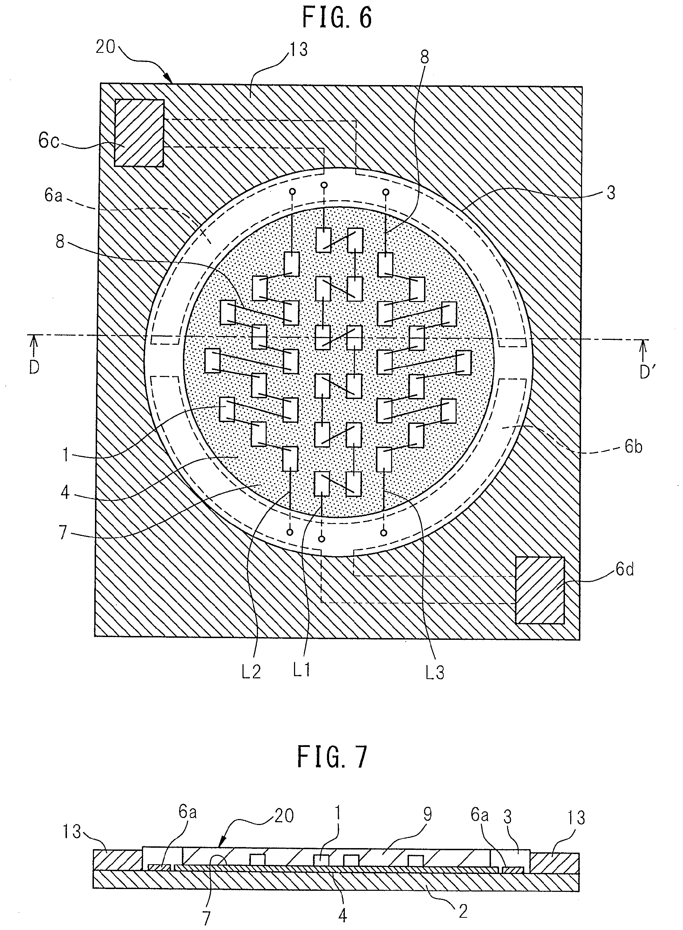

Figure 6 is a plan view of an alternative LED light emitting apparatus 20, and Figure 7 is a cross-sectional view taken along ling D-D' in Figure 6. In the alternative LED light emitting apparatus 20 shown in Figures 6 and 7, the same component elements as those in the LED light emitting apparatus 10 shown in Figures 1 and 2 are designated by the same reference numerals, and the description of such component elements will not be repeated here.

In the LED light emitting apparatus 10, the metal plate 5 is used as the mounting substrate, the circuit substrate 2 having a circular opening 2a in the center is placed on the metal plate 5, and the circular portion 5a of the metal plate 5 exposed through the opening 2a of the circuit substrate 2 is used as the circular device mounting region 7. By contrast, in the LED light emitting apparatus 20, a circuit substrate 2 having no openings is used as the mounting substrate, a circular reflective insulating layer 4 is formed in the center of the upper surface of the circuit substrate 2, and this circular reflective insulating layer 4 is used as the device mounting region 7.

In the LED light emitting apparatus 20, the reflective sealing frame 3 is formed so as to cover the LED connecting electrodes 6a and 6b on the upper surface of the circuit substrate 2 and so as to overlap the outer circumference of the reflective insulating layer 4. Further, in the LED light emitting apparatus 20, since the device mounting region 7 is enclosed by only the reflective members, i.e., the reflective insulating layer 4 and the reflective sealing frame 3, the light emitted from the LED devices 1 is not absorbed by the exposed portions of the circuit substrate 2 nor is it absorbed by the gold-plated layers formed on the LED connecting electrodes 6a and 6b. Furthermore, since the light emitted from the LED devices 1 is reflected by the reflective insulating layer 4 and the reflective sealing frame 3, the LED light emitting apparatus 20 achieves an extremely high reflective efficiency. In the LED light emitting apparatus 20, the reflective insulating layer 4 is formed from a white reflective resin layer formed by mixing reflective particles such as titanium oxide into a transparent resin, or from a white reflective insulating layer such as a ceramic ink layer.

In the LED light emitting apparatus 20, the arrangement of the LED devices 1, the connections made by the wires 8, the drive voltage supply, and the light-emitting driving operation are the same as those in the LED light emitting apparatus 10, the only difference being that the circuit substrate 2 is used as the mounting substrate and the reflective insulating layer 4 formed thereon is used as the device mounting region 7.

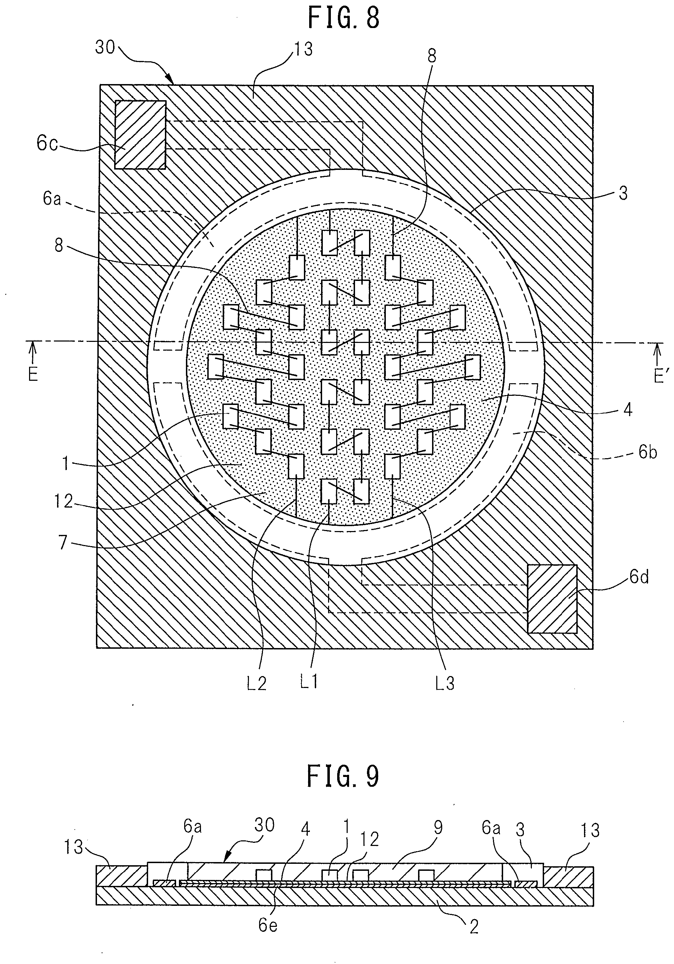

Figure 8 is a plan view of a further alternative LED light emitting apparatus 30, and Figure 9 is a cross-sectional view taken along ling E-E' in Figure 8. In the further alternative LED light emitting apparatus 30 shown in Figures 8 and 9, the same component elements as those in the LED light emitting apparatus 20 shown in Figures 6 and 7 are designated by the same reference numerals, and the description of such component elements will not be repeated here.

In the LED light emitting apparatus 20, the reflective insulating layer 4 is formed on the resin substrate of the circuit substrate 2, and this reflective insulating layer 4 is used as the device mounting region 7. By contrast, in the LED light emitting apparatus 30, a circular mounting electrode 6e is formed as a copper foil pattern in the center of the circuit substrate 2 independently of both the LED connecting electrodes 6a and 6b and the power connecting electrodes 6c and 6d. Further, a silver-plated layer as a plated reflective layer 12 is formed on the mounting electrode 6e, and the plated reflective layer 12 is covered with a transparent insulating layer to form the device mounting region 7. Furthermore, the LED connecting electrodes 6a and 6b and the power connecting electrodes 6c and 6d, formed by depositing copper foil patterns on the circuit substrate 2, are plated with gold to ensure good connections. Such an arrangement is made possible because the device mounting electrode 6e is formed so as to be electrically separated from both the LED connecting electrodes 6a and 6b and the power connecting electrodes 6c and 6d.

In the LED light emitting apparatus 30, the reflective sealing frame 3 is formed so as to cover the LED connecting electrodes 6a and 6b on the upper surface of the circuit substrate 2 and so as to overlap the outer circumference of the plated reflective layer 12. Further, in the LED light emitting apparatus 30, since the device mounting region 7 is enclosed by only the reflective members, i.e., the plated reflective layer 12 and the reflective sealing frame 3, the light emitted from the LED devices 1 is not absorbed by the exposed portions of the circuit substrate 2 nor is it absorbed by the gold-plated layers formed on the LED connecting electrodes 6a and 6b. Furthermore, in the LED light emitting apparatus 30, since all the light emitted from the LED devices 1 is reflected by the plated reflective layer 12 and the reflective resin frame 3, the LED light emitting apparatus 30 achieves an extremely high reflective efficiency. Moreover, in the LED light emitting apparatus 30, since the mounting electrode 6e formed by depositing a copper foil pattern is used as the device mounting region 7, the structure serves to increase heat dissipation from the LED devices 1 fixedly mounted on the copper foil pattern.

Any of the above-described LED light emitting apparatus 10, 20, and 30 can be applied as an LED light emitting apparatus that produces white light by wavelength conversion using a phosphor layer. For example, an LED light emitting apparatus that produces white light can be constructed by using blue LEDs as the LED devices 1 and using in combination a YAG phosphor layer as the sealing resin 9. An LED light emitting apparatus that produces white light can also be constructed by using ultraviolet LEDs as the LED devices 1 and using in combination an RGB phosphor layer as the sealing resin 9.

In the above-described LED light emitting apparatus 10, 20, and 30, the reflective layer is formed in the device mounting region, the opposing electrodes are plated with gold, and the reflective sealing frame is formed around the device mounting region in such a manner that the inner circumference of the sealing frame overlaps the outer circumference of the reflective layer. With this arrangement, in the LED light emitting apparatus 10, 20, and 30, not only can the reflectivity of the device mounting region be increased, but the bondability of the LED devices to the opposing electrodes can also be improved, thus making it possible to improve both the optical characteristics and the connection reliability. Furthermore, in the LED light emitting apparatus 10, 20, and 30, it becomes possible to enhance the light-emitting characteristics by forming the device mounting region in a circular shape and arranging the LED devices in a near circular geometry. In the LED light emitting apparatus 10 and 30, it also becomes possible to increase heat dissipation from the LED devices by using the metal plate or a copper foil pattern formed on the circuit substrate as the mounting substrate.

### DESCRIPTION OF THE REFERENCE NUMERALS

- 1: LED DEVICE
- 2: CIRCUIT SUBSTRATE
- 2a: OPENING
- 3: SEALING FRAME
- 4: INSULATING REFLECTIVE LAYER
- 5: METAL PLATE
- 5a: CIRCULAR PORTION
- 6a, 6b: LED CONNECTING ELECTRODE
- 6c, 6d: POWER CONNECTING ELECTRODE
- 6e: MOUNTING ELECTRODE
- 7: DEVICE MOUNTING REGION
- 8: WIRE
- 9: SEALING RESIN
- 10, 20, 30: LED LIGHT EMITTING APPARATUS
- 11: REFLECTIVE LAYER
- 12: PLATED REFLECTIVE LAYER
- 13, 13': RESIST
- 13a, 13b: OPENING

## Claims

1. An LED light emitting apparatus comprising:
a mounting substrate (5) having a device mounting region (7) in which a reflective layer (11) is formed;
a plurality of LED devices (1) mounted in said device mounting region;
a pair of opposing electrodes (6a, 6b) being arranged around said device mounting region and being connected to said plurality of LED devices by means of wire bonding; and
a sealing frame (3) formed around said device mounting region so as to cover said pair of opposing electrodes,
wherein an inner circumference of said sealing frame overlaps an outer circumference of said reflective layer,
**characterized by**
a gold-plated layer formed on said pair of opposing electrodes, and
a resist layer (13') intervening between said pair of opposing electrodes and said sealing frame and having openings (13b) at positions where said plurality of LED devices are connected to said opposing electrodes by means of wire bonding.

2. The LED light emitting apparatus according to claim 1, wherein said reflective layer is a metal plate that covers a bottom face exposed through an opening (2a) formed in a circuit substrate (2) on which said pair of opposing electrodes is formed, and wherein said sealing frame is formed so as to cover a portion extending from an upper face of said circuit substrate to a side face of said opening and further to a surface of said metal plate.

3. The LED light emitting apparatus according to claim 2, wherein said metal plate is an aluminum plate.

4. The LED light emitting apparatus according to claim 2 or 3, wherein said reflective layer is an insulating film treated for high reflectivity formed on the surface of said metal plate.

5. The LED light emitting apparatus according to claim 1, wherein said reflective layer is a white reflective insulating layer formed on a circuit substrate on which said pair of opposing electrodes is formed, and wherein said sealing frame is formed so as to cover a portion extending from an upper face of said circuit substrate and overlapping the outer circumference of said white reflective layer.

6. The LED light emitting apparatus according to claim 5, wherein said white reflective layer is a ceramic ink layer or a white reflective resin layer.

7. The LED light emitting apparatus according to claim 5, wherein said white reflective layer is formed by depositing a silver-plated layer and a transparent insulating layer one on top of the other on said circuit substrate on which said pair of opposing electrodes is formed.

8. The LED light emitting apparatus according to any one of claims 1 to 7, wherein said reflective layer formed in said device mounting region has a circular shape.

9. The LED light emitting apparatus according to any one of claims 1 to 8, wherein said sealing frame is formed from a reflective white resin.

10. The LED light emitting apparatus according to any one of claims 1 to 9, further comprising a phosphor layer, formed inside said sealing frame, for modulating light emitted from said plurality of LED devices and thereby converting said light into white light.

11. The LED light emitting apparatus according to claim 10, wherein said plurality of LED devices are blue LED devices, and said phosphor layer is a YAG phosphor layer.

12. The LED light emitting apparatus according to claim 10, wherein said plurality of LED devices are ultraviolet LED devices, and said phosphor layer is an RGB phosphor layer.

## Patentansprüche

1. Lichtemittierende LED-Vorrichtung, umfassend:
ein Montagesubstrat (5) mit einem Bauelementmontagebereich (7), in dem eine reflektierende Schicht (11) ausgebildet ist,
eine Mehrzahl von LED-Bauelementen (1), die im Bauelementmontagebereich angebracht sind,
ein Paar gegenüberliegender Elektroden (6a, 6b), die um den Bauelementmontagebereich herum angeordnet sind und mit der Mehrzahl von LED-Bauelementen mittels Drahtbonden verbunden sind, und
einen Dichtungsrahmen (3), der um den Bauelementmontagebereich herum so angeordnet ist, dass das Paar gegenüberliegender Elektroden bedeckt ist,
wobei ein Innenumfang des Dichtungsrahmens einen Außenumfang der reflektierenden Schicht überlappt,
**gekennzeichnet durch**
eine gold-plattierte Schicht, die auf dem Paar gegenüberliegender Elektroden ausgebildet ist, und
eine Resistschicht (13') angeordnet zwischen dem Paar gegenüberliegender Elektroden und dem Dichtungsrahmen und mit Öffnungen (13b) an Positionen, an denen die Mehrzahl von LED-Bauelementen mit den gegenüberliegenden Elektroden mittels Drahtbonden verbunden sind.

2. Lichtemittierende LED-Vorrichtung nach Anspruch 1, wobei die reflektierende Schicht als Metallplatte ausgebildet ist, die eine Unterseite bedeckt, die durch eine Öffnung (2a) freigelegt ist, die in einem Schaltungssubstrat (2) ausgebildet ist, auf dem das Paar gegenüberliegender Elektroden ausgebildet ist, und wobei der Dichtungsrahmen so ausgebildet ist, dass er einen Abschnitt bedeckt, der sich von einer Oberseite des Schaltungssubstrats zu einer Seitenfläche der Öffnung und weiter zu einer Oberfläche der Metallplatte erstreckt.

3. Lichtemittierende LED-Vorrichtung nach Anspruch 2, wobei die Metallplatte als Aluminiumplatte ausgebildet ist.

4. Lichtemittierende LED-Vorrichtung nach Anspruch 2 oder 3, wobei die reflektierende Schicht als Isolierfilm ausgebildet ist, der auf der Oberfläche der Metallplatte ausgebildet und für hohes Reflexionsvermögen behandelt ist.

5. Lichtemittierende LED-Vorrichtung nach Anspruch 1, wobei die reflektierende Schicht als weiß reflektierende Isolierschicht auf einem Schaltungssubstrat ausgebildet ist, auf dem das Paar gegenüberliegender Elektroden ausgebildet ist, und wobei der Dichtungsrahmen so ausgebildet ist, dass er einen Abschnitt bedeckt, der sich von einer Oberseite des Schaltungssubstrats erstreckt und den Außenumfang der weiß reflektierenden Schicht überlappt.

6. Lichtemittierende LED-Vorrichtung nach Anspruch 5, wobei die weiß reflektierende Schicht als Keramikfarbschicht oder als weiß reflektierende Harzschicht ausgebildet ist.

7. Lichtemittierende LED-Vorrichtung nach Anspruch 5, wobei die weiß reflektierende Schicht ausgebildet ist durch Abscheiden einer silber-plattierten Schicht und einer transparenten Isolierschicht übereinander auf dem Schaltungssubstrat, auf dem das Paar gegenüberliegender Elektroden ausgebildet ist.

8. Lichtemittierende LED-Vorrichtung nach einem der Ansprüche 1 bis 7, wobei die im Bauelementmontagebereich ausgebildete reflektierende Schicht eine runde Form aufweist.

9. Lichtemittierende LED-Vorrichtung nach einem der Ansprüche 1 bis 8, wobei der Dichtungsrahmen aus einem weiß reflektierenden Harz gebildet ist.

10. Lichtemittierende LED-Vorrichtung nach einem der Ansprüche 1 bis 9, weiter umfassend eine Leuchtstoffschicht, die innerhalb des Dichtungsrahmens ausgebildet ist, zum Modulieren von Licht, das aus der Mehrzahl von LED-Bauelementen emittiert wird, und dadurch Umwandeln des Lichts in weißes Licht.

11. Lichtemittierende LED-Vorrichtung nach Anspruch 10, wobei die Mehrzahl von LED-Bauelementen blaue LED-Bauelemente sind und die Leuchtstoffschicht eine YAG-Leuchtstoffschicht ist.

12. Lichtemittierende LED-Vorrichtung nach Anspruch 10, wobei die Mehrzahl von LED-Bauelementen ultraviolette LED-Bauelemente sind und die Leuchtstoffschicht eine RGB-Leuchtstoffschicht ist.

## Revendications

1. Appareil lumineux à diodes électroluminescentes (DEL) comprenant :
un substrat de montage (5) présentant une région de montage (7) de dispositif dans laquelle une couche réfléchissante (11) est formée ;
une pluralité de dispositifs DEL (1) montés dans ladite région de montage de dispositif ;
une paire d'électrodes (6a, 6b) opposées étant arrangées autour de ladite région de montage de dispositif et étant connectées à ladite pluralité de dispositifs DEL au moyen de câblage filaire ; et
un cadre d'étanchéité (3) formé autour de ladite région de montage de dispositif de manière à couvrir ladite paire d'électrodes opposées,
dans lequel une circonférence intérieure dudit cadre d'étanchéité chevauche une circonférence extérieure de ladite couche réfléchissante,
**caractérisé par**
une couche plaqué d'or formée sur ladite paire d'électrodes opposées, et
une couche de résist (13') intervenant entre ladite paire d'électrodes opposées et ledit cadre d'étanchéité et présentant ouvertures (13b) à positions où ladite pluralité de dispositifs DEL sont connectés aux électrodes opposées au moyen de câblage filaire.

2. Appareil lumineux à DEL selon la revendication 1, dans lequel ladite couche réfléchissante est une plaque métallique qui couvre une face de bas exposée à travers une ouverture (2a) formée dans un substrat de circuit (2) sur lequel ladite paire d'électrodes opposées est formée, et dans lequel ledit cadre d'étanchéité est formée de manière à couvrir une partie s'étendant à partir d'une face supérieure dudit substrat de circuit vers une face latérale de ladite ouverture et en outre vers une surface de ladite plaque métallique.

3. Appareil lumineux à DEL selon la revendication 2, dans lequel ladite plaque métallique est une plaque en aluminium.

4. Appareil lumineux à DEL selon la revendication 2 ou 3, dans lequel ladite couche réfléchissante est un film isolant traité pour une réflectivité élevée formé sur la surface de ladite plaque métallique.

5. Appareil lumineux à DEL selon la revendication 1, dans lequel ladite couche réfléchissante est une couche isolante réfléchissante blanc formée sur un substrat de circuit sur lequel ladite paire d'électrodes opposées est formée, et dans lequel ledit cadre d'étanchéité est formé de manière à couvrir une partie s'étendant à partir d'une face supérieure dudit substrat de circuit et chevauchant la circonférence extérieure de ladite couche réfléchissante blanc.

6. Appareil lumineux à DEL selon la revendication 5, dans lequel ladite couche réfléchissante blanc est une couche d'encre céramique ou une couche de résine réfléchissante blanc.

7. Appareil lumineux à DEL selon la revendication 5, dans lequel ladite couche réfléchissante blanc est formée par le dépôt d'une couche plaqué d'argent et une couche isolante transparente l'une au-dessus de l'autre sur ledit substrat de circuit sur lequel ladite paire d'électrodes opposées est formée.

8. Appareil lumineux à DEL selon l'une quelconque des revendications 1 à 7, dans lequel ladite couche réfléchissante formée dans ladite région de montage de dispositif présente une forme circulaire.

9. Appareil lumineux à DEL selon l'une quelconque des revendications 1 à 8, dans lequel ledit cadre d'étanchéité est formé d'une résine réfléchissante blanc.

10. Appareil lumineux à DEL selon l'une quelconque des revendications 1 à 9, en outre comprenant une couche luminophore, formée au sein du cadre d'étanchéité, pour moduler lumière émise par ladite pluralité de dispositifs DEL et de convertir ainsi ladite lumière en lumière blanche.

11. Appareil lumineux à DEL selon la revendication 10, dans lequel ladite pluralité de dispositifs DEL sont des dispositifs DEL bleus et ladite couche luminophore est une couche luminophore YAG.

12. Appareil lumineux à DEL selon la revendication 10, dans lequel ladite pluralité de dispositifs DEL sont des dispositifs DEL ultraviolets et ladite couche luminophore est une couche luminophore RVB.
